# EUROPEAN PATENT APPLICATION

(11) **EP 4 527 974 A2**
(43) Date of publication of application: **26.03.2025**
(21) Application number: 24198675.1
(22) Date of filing: 05.09.2024
(51) Int. Cl.: C23C 16/44, H01J 37/32

(54) **METHOD AND APPARATUS FOR CLEANING A REACTION CHAMBER**

(30) Priority: 05.09.2023 FI 20235989
(71) Applicant: Picosun Oy, 02150 Espoo (FI)
(72) Inventor: BLOMBERG, Tom, 02430 Masala (FI); KILPI, Väinö, 02430 Masala (FI); RISSA, Veli-Matti, 02430 Masala (FI)
(74) Representative: Espatent Oy

(57) **Abstract**

A method and substrate processing apparatus (100) for cleaning a reaction chamber (110) of the substrate processing apparatus (100), wherein cleaning gas is provided from a cleaning gas source (190), a first cleaning gas flow is fed through a first inlet (120) and a second cleaning gas flow through a second inlet (180) into the reaction chamber (110) for etching the reaction chamber, wherein the first cleaning gas flow and the second cleaning gas flow enter the reaction chamber (110) from different directions, and wherein the cleaning gas is activated before said etching.

## Description

### TECHNICAL FIELD

The present disclosure generally relates to the cleaning of a substrate processing apparatus. The disclosure relates particularly, though not exclusively, to the cleaning of a reaction chamber.

### BACKGROUND

This section illustrates useful background information without admission of any technique described herein representative of the state of the art.

In various substrate processing apparatuses, various chemicals are fed into a reaction chamber. During use, the chemicals may accumulate on the reaction chamber walls and the accumulated chemicals may contaminate the chemical reactions or processes on a substrate. The residues and contamination of the previously entered chemicals should be cleaned from the reaction chamber as effectively as possible to maintain reaction quality.

### SUMMARY

It is an object of certain embodiments of the invention to provide a method and apparatus to improve reaction chamber cleaning.

The appended claims define the scope of protection. Any examples and technical descriptions of apparatuses, products and/or methods in the description and/or drawings not covered by the claims are presented not as embodiments of the invention but as background art or examples useful for understanding the invention.

According to a first example aspect there is provided a method for cleaning a reaction chamber of a substrate processing apparatus, comprising:
providing cleaning gas from a cleaning gas source;
feeding a first cleaning gas flow through a first inlet and a second cleaning gas flow through a second inlet into the reaction chamber for etching the reaction chamber, wherein the first cleaning gas flow and the second cleaning gas flow enter the reaction chamber from different directions; and
activating the cleaning gas before said etching.

Accordingly, in certain embodiments, the first cleaning gas flow enters the reactions chamber from a certain direction (or position), and the second cleaning gas flow from another direction (or position). In certain embodiments, the first cleaning gas flow enters the reaction chamber from the top (or top section) of the reaction chamber, and the second cleaning gas flow enters the reaction chamber from the bottom (or bottom section) of the reaction chamber or from a substrate support.

In certain embodiments, the said activating comprises decomposing the cleaning gas with plasma. In certain embodiments, the said activating comprises forming plasma from the cleaning gas.

In certain embodiments, the said activating comprises at least one of decomposing the cleaning gas with plasma and forming plasma from the cleaning gas.

In certain embodiments, the method comprises feeding the cleaning gas into the reaction chamber simultaneously through the first inlet and the second inlet. Advantageously, injecting the cleaning gas through two opposite inlets may improve cleaning gas distribution in the reaction chamber.

In certain embodiments, the method comprises feeding the cleaning gas into the reaction chamber sequentially through the first inlet and the second inlet. Advantageously, cleaning may sequentially be focused on different parts of the reaction chamber.

In certain embodiments, the cleaning gas is a fluorine-based gas. In certain embodiments, the cleaning gas is NF3. In certain embodiments, the fluorine-based cleaning gas is selected from the group of NF3, SF6, CF4, CHxFy and F2. In certain embodiments, the fluorine-based cleaning gas is selected from a group including but not limited to NF3, SF6, CF4, CHxFy and F2. Advantageously, when activated with plasma, the fluorine-based gas decomposes to atomic fluorine gas and other reactive by-products that react willingly with almost all materials. Thus, effective reaction chamber cleaning may be achieved.

In certain embodiments, the cleaning gas of the first cleaning gas flow is different from the cleaning gas of the second cleaning gas flow. Advantageously, different combinations of cleaning gases may be used.

In certain embodiments, the second inlet is a substrate backside protection channel. In certain embodiments, the second cleaning gas flow enters the reaction chamber from below through a substrate support. In certain embodiments, the second cleaning gas flow enters the reaction chamber from below through inside of a substrate support. Accordingly, in certain embodiments, said feeding a second cleaning gas flow through a second inlet comprises feeding said second cleaning gas flow through a substrate support (or through inside of a substrate support). Advantageously, existing structures of the substrate processing apparatus may be used to deliver the cleaning gas into the reaction chamber and the need for structural modifications may be mitigated.

In certain embodiments, the first inlet and the second inlet are opposite to each other. In certain embodiments, the first cleaning gas flow enters the reaction chamber through the top of the reaction chamber via the first inlet and the second cleaning gas flow enters through the bottom of the reaction chamber via the second inlet opposite to the first inlet. Advantageously, opposite flows of cleaning gas improve gas distribution in the reaction chamber. Consequently, less cleaning gas may be needed.

In certain embodiments, at least one of the two inlets is also used for feeding reaction chemicals during substrate processing. Advantageously, same structures of the substrate processing apparatus may be used for substrate processing and for the cleaning process.

In certain embodiments, the method comprises repeating the method for a predetermined number of times. Advantageously, by repeating the method, cleaning efficacy may be improved. In certain embodiments, changing the cleaning parameters for each repetition cycle may further improve the cleaning efficacy.

In certain embodiments, the method comprises:
activating the cleaning gas with plasma formed in a separate (remote or separate from the reaction chamber) plasma formation unit.

In certain embodiments, the method comprises:
activating the cleaning gas with plasma formed in a plasma formation unit integrated into the reaction chamber.

In certain embodiments, the method comprises:
activating the cleaning gas of the first cleaning gas flow and the cleaning gas of the second cleaning gas flow with plasma formed in a single plasma formation unit.

In certain embodiments, the method comprises:
forming plasma for activating the cleaning gas and forming plasma for substrate processing in a same (preferably integrated) plasma formation unit.

In certain embodiments, the duration of the first cleaning gas flow and the second cleaning gas flow are independently controlled. Advantageously, a combined cleaning gas flow may be more accurately directed towards certain parts of the reaction chamber, for example, the top part or parts that may be difficult to clean with conventional solutions. Different durations may allow redirecting the cleaning gas flow and changing of the focus area of the cleaning inside the reaction chamber during a cleaning process.

In certain embodiments, the flow rates of the first cleaning gas flow and the second cleaning gas flow are independently controlled. Advantageously, a combined cleaning gas flow may be more accurately directed towards certain parts of the reaction chamber, for example, the top part or parts where contamination that is more difficult to clean typically occurs.

In certain embodiments, the method comprises:
targeting cleaning gas flow inside the reaction chamber by controlling the duration and/or the flow rate of the first cleaning gas flow and the second cleaning gas flow. Advantageously, the highest cleaning gas dosage may be targeted to the most contaminated parts of the reaction chamber.

In certain embodiments, the duration of the first cleaning gas flow is equal to the duration of the second cleaning gas flow. Advantageously, cleaning gas may be effectively delivered from two opposite directions to improve gas distribution inside the reaction chamber.

In certain embodiments, the flow rate of the first cleaning gas flow is equal to the flow rate of the second cleaning gas flow. Advantageously, cleaning gas may be effectively delivered from two opposite directions to improve gas distribution inside the reaction chamber.

According to a second example aspect there is provided a substrate processing apparatus, comprising:
a reaction chamber;
a first inlet to feed cleaning gas as a first cleaning gas flow from a cleaning gas source into the reaction chamber;
a second inlet to feed cleaning gas, from a direction that differs from a direction of feed of the first cleaning gas flow, as a second cleaning gas flow from the cleaning gas source into the reaction chamber; and
a plasma formation unit configured to activate the cleaning gas for etching the reaction chamber.

In certain embodiments, the plasma formation unit is configured to activate cleaning gas by at least one of decomposing the cleaning gas with plasma and forming plasma from the cleaning gas.

In certain embodiments, the plasma formation unit is an integrated plasma formation unit integrated into the reaction chamber (for forming plasma to activate the cleaning gas inside the reaction chamber). Advantageously, the same integrated plasma formation unit that is used in plasma formation during substrate processing may also be used to form plasma to activate the cleaning gas during the cleaning process.

In certain embodiments, the substrate processing apparatus comprises a remote plasma formation unit for forming plasma to activate the cleaning gas before feeding the cleaning gas into the reaction chamber. In certain embodiments, the cleaning gas flows from both the first and second inlets already contain plasma-activated cleaning gas upon entering the reaction chamber. Hence, etching is effectively targeted to the directions of the flows.

In certain embodiments, the first inlet line and the second inlet line are opposite to each other. In certain embodiments, the apparatus is configured to route the first cleaning gas flow through the top (or through a top part) of the reaction chamber and the second cleaning gas flow through a substrate support. In certain embodiments, the first cleaning gas flow causes a top-to-bottom flow within the reaction chamber, and the second cleaning gas flow a bottom-to-top flow. Accordingly, in certain embodiments, the apparatus is configured to spread the first cleaning gas flow in the reaction chamber laterally with the second cleaning gas flow.

In certain embodiments, the substrate processing apparatus is configured to feed the first cleaning gas flow and the second cleaning gas flow simultaneously into the reaction chamber.

In certain embodiment, the substrate processing apparatus is configured to feed the first cleaning gas flow and the second cleaning gas flow sequentially into the reaction chamber.

In certain embodiments, the cleaning gas is a fluorine-based gas. In certain embodiments, the cleaning gas is NF3. In certain embodiments, the fluorine-based cleaning gas is selected from the group of NF3, SF6, CF4, CHxFy and F2. In certain embodiments, the fluorine-based cleaning gas is selected from a group including but not limited to NF3, SF6, CF4, CHxFy and F2.

In certain embodiments, the cleaning gas of the first cleaning gas flow (from the first inlet line) is different from the cleaning gas of the second cleaning gas flow (from the second inlet line).

In certain embodiments, the second inlet is a substrate backside protection channel.

Different non-binding example aspects and embodiments have been illustrated in the foregoing. The embodiments in the foregoing are used merely to explain selected aspects or steps that may be utilized in different implementations. Some embodiments may be presented only with reference to certain example aspects. It should be appreciated that corresponding embodiments may apply to other example aspects as well.

### BRIEF DESCRIPTION OF THE FIGURES

Some example embodiments will be described with reference to the accompanying figures, in which:
Fig. 1 shows a sectional view of a substrate processing apparatus according to an example embodiment;
Fig. 2 shows a further sectional view of a substrate processing apparatus according to an example embodiment; and
Fig. 3 shows a flow chart according to an example embodiment.

### DETAILED DESCRIPTION

In the following description, like reference signs denote like elements or steps.

In the following description, Atomic Layer Deposition (ALD) technology is used as an example. However, the invention is not limited to ALD technology, but it can be exploited in a wide variety of substrate processing apparatuses, for example, in Chemical Vapor Deposition (CVD) reactors, or in etching reactors, such as in Atomic Layer Etching (ALE) reactors.

The basics of an ALD growth mechanism are known to a skilled person. ALD is a special chemical deposition method based on the sequential introduction of typically at least two reactive precursor species to at least one substrate. It is to be understood, however, that one of these reactive precursors can be substituted by energy when using, for example, photon-enhanced ALD or plasma-assisted ALD, for example PEALD, leading to single precursor ALD processes. Thin films grown by ALD are dense, pinhole free and have uniform thickness.

As for substrate processing steps, the at least one substrate is typically exposed to temporally separated precursor pulses in a reaction vessel to deposit material on the substrate surfaces by sequential self-saturating (or self-limiting) surface reactions. In the context of this application, the term ALD comprises all applicable ALD based techniques and any equivalent or closely related technologies, such as, for example, MLD (Molecular Layer Deposition).

During the substrate processing, undesired accumulation of reaction chemicals inside the reaction chamber may occur. To maintain the chemical process quality, the reaction chamber should be effectively cleaned. The reaction chamber may be cleaned by etching.

For example, nitrogen trifluoride, NF3, is a widely used chamber cleaning gas in substrate processing apparatuses. When activated with plasma generated by a plasma formation (or activation) unit, the NF3 molecule decomposes to atomic fluorine gas and other reactive by-products that react willingly with almost all materials. Plasma to activate the NF3 gas may be, for example, argon or nitrogen plasma, which then decomposes the NF3 molecules. Additionally or alternatively, activation of NF3 may comprise using NF3 as a plasma precursor and to generate plasma from the NF3. That is, activating the cleaning gas comprises at least one of decomposing the cleaning gas with plasma and forming plasma from the cleaning gas. NF3 plasma may be used to decompose NF3 cleaning gas, or to etch the reaction chamber. Other fluorine compounds besides NF3 may be used too. In general, the fluorine compounds of many materials are volatile and therefore gaseous fluorine chemistry can be used as cleaning to etch solid materials from surfaces of the chambers.

In certain embodiments, the cleaning gas is a fluorine-based gas. In certain embodiments, the cleaning gas is NF3. In certain embodiments, the fluorine-based cleaning gas is selected from the group of NF3, SF6, CF4, CHxFy and F2. In certain embodiments, the fluorine-based cleaning gas is selected from a group including but not limited to NF3, SF6, CF4, CHxFy and F2.

However, a major challenge is the spreading of the reactive fluorine species or the cleaning gas plasma within the reaction chamber. If the active fluorine compounds or plasma do not reach all parts of the reaction chamber, the etching rate may be very different in different locations of the reaction chamber surfaces. If the dosages of the reactive fluorine species and cleaning gas plasma at the surfaces of the reaction chamber vary substantially, it may lead to the need for substantial over etching time for the chamber cleaning step. Accordingly, the reaction chamber surface location that experiences the lowest dosage (determined as partial pressure x time) of the active cleaning gas species during the etching step determines the minimum time needed for the chamber cleaning. It is desirable to use the minimum amount of fluorine-based cleaning gas in the etching step. The current disclosure addresses, *inter alia,* the above-mentioned issues.

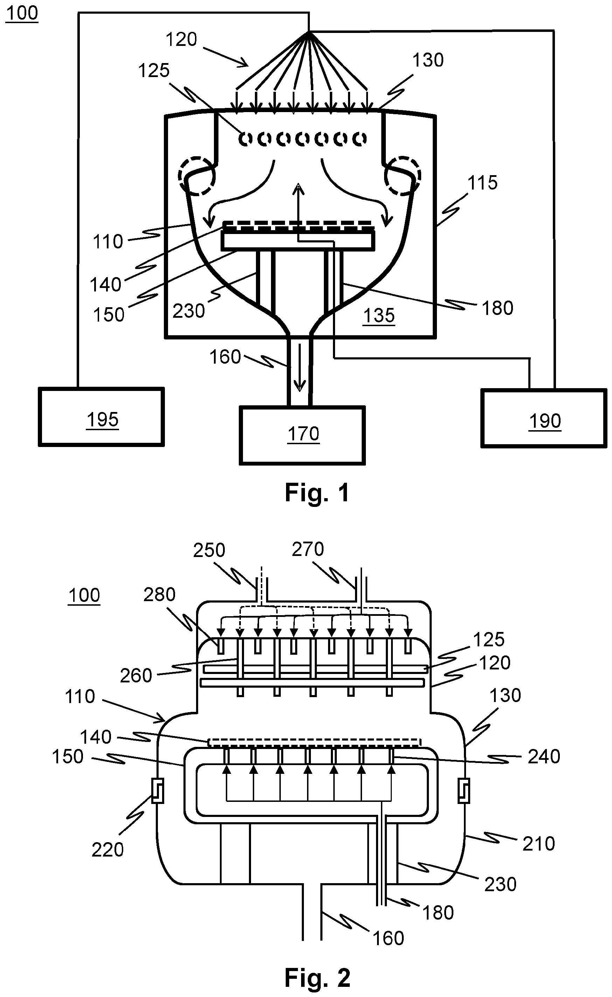

Fig. 1 shows an apparatus in accordance with certain embodiments. The apparatus 100 is a substrate processing apparatus, for example, an ALD, ALE or CVD reactor. The apparatus 100 comprises a reaction chamber 110 and a first inlet 120. Reaction chemicals and the first cleaning gas flow may be fed into the reaction chamber 110 through the first inlet 120. In the embodiment of Fig. 1, the first inlet 120 comprises a plurality of inlet holes in a ceiling of the reaction chamber 110. In certain embodiments, the reaction gases and precursors are fed into the reaction chamber 110 through the plurality of inlet holes of the first inlet 120, as shown by the plurality of arrows depicting reactant flow to the reaction chamber 110, to improve the distribution of the fed gases into the reaction chamber 110. In certain embodiments, the first inlet 120 comprises a showerhead.

In certain embodiments, the apparatus comprises an outer chamber 115. The outer chamber 115 at least partially surrounds the reaction chamber 110. An intermediate volume 135 is formed between the outside walls of the reaction chamber 110 and inside of the outer chamber 115 walls. In certain embodiments, the pressure in the intermediate volume 135 is kept higher than the pressure in the reaction chamber 110 during cleaning, for example, to prevent leakage from the reaction chamber 110. For instance, the pressure in the intermediate volume 135 may be 4 hPa and the pressure in the reaction chamber less than 2 hPa during a cleaning process.

A plurality of plasma antennae 125 are located downstream of the inlet holes of the first inlet 120. In certain embodiments, the plasma antennae are used to form plasma from plasma precursors, that are fed through the first inlet 120. In certain embodiments, the plasma antennae are used to form plasma from plasma precursors for both activating the NF3 cleaning gas flow for the cleaning step and for substrate processing. Herein NF3 is used as an exemplary cleaning gas but other fluorine-based cleaning gases are possible too. The plasma may be, for example, argon plasma, or nitrogen plasma. In certain embodiments, the plasma antennae are used to form plasma from the NF3 cleaning gas. Therefore, activating the cleaning gas comprises at least one of decomposing the cleaning gas with plasma and forming plasma from the cleaning gas.

The plasma antennae 125 may emit electromagnetic radiation and/or form an electric and/or magnetic field around them. The plasma is formed around and on the surfaces of the plasma antennae 125 but may spread into the reaction chamber too. Hence, NF3 plasma is usable for both NF3 cleaning gas activation and/or chamber etching. A first cleaning gas flow of NF3 is provided from a cleaning gas source 190. A plasma precursor flow is provided from a plasma precursor source 195. In certain embodiments, the plasma precursor flow serves both the chamber cleaning and the substrate processing operations. In certain embodiments, both the first cleaning gas flow and the plasma precursor flow enter the reaction chamber 110 through the first inlet 120. Cleaning gas (a second cleaning gas flow) may also enter the reaction chamber 110 via a substrate backside protection channel 180.

In certain embodiments, the reaction chamber 110 is a cylinder that is rounded on the bottom. Its horizontal cross section is circular, in general. The reaction chamber 110 is a vertical flow reaction chamber meaning that gas flow within the reaction chamber 110 generally occurs from top to bottom. The gases exit through an outlet 160, which is connected to a vacuum pump 170.

The first inlet 120 is coupled to (or forms part of) a top part 130 of the reaction chamber 110. In certain embodiments, the top part 130 is configured to operate as, or the top part 130 comprises, a lid that can be opened for loading a substrate 140 (such as a wafer), or a plurality of substrates 140, onto a substrate support 150 or for removing the substrate(s) from the reaction chamber 110. In certain embodiments, the top part 130 is removable, whereas in other embodiments a reaction chamber bowl 210, that is, the lower part of the reaction chamber 110, can be lowered to load or remove substrates. In certain alternative embodiments, a door is formed on a side of the reaction chamber 110 to load or remove the substrate(s) 140.

The substrate support 150 is centrally positioned in a horizontal direction, or in all horizontal directions. In certain embodiments, the substrate support 150 is attached to a wall of the reaction chamber 110. In certain embodiments, the substrate support 150 stands on supporting legs 230 inside the reaction chamber 110. In alternative embodiments, the substrate support 150 is hanging from the lid 130.

In certain embodiments, a second inlet 180 for cleaning gas to enter the reaction chamber 110 is arranged from below, into the connection of the substrate support 150. The second inlet 180 feeds the second cleaning gas flow to the reaction chamber 110. In certain embodiments, the second inlet 180 enters the reaction chamber 110 from different direction than the first inlet 120. That is, the first cleaning gas flow from the first inlet 120 and the second cleaning gas flow from the second inlet 180 are at least partially directed to different directions. In certain embodiments, the first inlet 120 and the second inlet 180 are opposite to each other. In certain embodiments, the first and second cleaning gas flows from the first inlet 120 and second inlet 180, respectively, are directed at least partially to opposite directions. In certain embodiments, the first inlet 120 and second inlet 180 are positioned such that the first cleaning gas flow and the second cleaning gas flow are at least partially directed towards each other.

In certain embodiments, cleaning gas to the second inlet 180 travels through the supporting leg(s) 230 of the substrate support 150 and the substrate support 150 into the reaction chamber 110. The second inlet 180, like the first inlet 120, is connected to the cleaning gas source 190. In certain embodiments, both the first cleaning gas flow and the second cleaning gas flow are provided from the same cleaning gas source 190.

In certain embodiments, the apparatus 100 comprises more than one cleaning gas sources 190. In certain embodiments, the first inlet 120 and the second inlet 180 are connected to separate cleaning gas sources 190. In certain embodiments, the cleaning gas of the first cleaning gas flow is different from the cleaning gas of the second cleaning gas flow from.

In the embodiment of Fig. 1, the second inlet 180 is (or forms part of) a substrate backside protection channel. The backside protection channel 180 is a gas channel located in the substrate support (or substrate holder assembly) 150. During substrate processing, the backside protection channel 180 feeds inert gas from below the substrate 140 to prevent reactions occurring on the backside of the substrate 140. That is, the backside protection channel may be used as the second inlet 180 in addition to its normal substrate processing function. The substrate 140 is not in the reaction chamber 110 when the chamber cleaning is performed so that the substrate 140 does not block the second cleaning gas flow from entering the reaction chamber 110.

In certain embodiments according to Fig. 1, both the first inlet 120 and the second inlet 180 feed cleaning gas, as the first cleaning gas flow and the second cleaning gas flow, respectively, to the reaction chamber 110 during chamber cleaning. The chamber cleaning may be performed, e.g., during pre- or postdeposition step during the processing of the substrate(s) 140. The second inlet 180 is located opposite to the first inlet 120 and is arranged to provide the second cleaning gas flow to enter the reaction chamber 100 from below and through the substrate support 150. The opposite first and second inlets 120, 180 provide the opposite first and second cleaning gas flows, respectively. The opposite first and second cleaning gas flows are directed at least partially to opposite directions. In certain embodiments, the first and second cleaning gas flows are directed at least partially towards each other. In certain embodiments, NF3 is injected to the reaction chamber 110 from both top and bottom. That is, the NF3 cleaning gas is routed from the cleaning gas source 190, through both the first inlet 120 and the second inlet 180, to be injected into the reaction chamber 110 from the two opposite inlets 120, 180.

In certain embodiments, the cleaning gas is injected simultaneously from two inlets that enter the reaction chamber from different directions. Therefore, the first and second inlet flows are directed at least partially to different directions. In certain embodiments, the two inlets comprise the first inlet 120 and/or the substrate backside protection channel 180. In certain embodiments, the first inlet 120 and second inlet 180 are opposite to each other. The first inlet 120 and the second inlet feed the first cleaning gas flow and second cleaning gas flow, respectively, to the reaction chamber 110 from different directions.

In certain embodiments, the cleaning gas is fed sequentially by alternating between the two inlets 120, 180. In certain embodiments, the cleaning gas is injected first from the second inlet 180 (, e.g., bottom) and then from the first inlet 120 (e.g., top). In certain embodiments, the cleaning gas is injected first from the first inlet 120 (e.g., top) and then from the second inlet 180 (e.g., bottom). In certain embodiments, at least one of the first inlet 120 and the second inlet 180 is located at the side of the reaction chamber 100.

In certain embodiments, the sequential injection cycle is repeated. In certain embodiments, the sequential cleaning gas injection cycle is repeated 1, 2, or 3 times. In certain embodiments, the same cleaning gas is provided through both first inlet 120 and second inlet 180. In certain embodiments, different cleaning gases are provided through first inlet 120 and second inlet 180.

The arrows in Fig. 1 visualize the flow and spreading of the cleaning gas. In certain embodiments, the NF3 gas from the cleaning gas source 190 is decomposed to atomic fluorine gas and other reactive by-products by activating it with plasma generated in a separate remote plasma formation unit (not shown). For example, argon plasma or nitrogen plasma may be used to decompose, i.e., activate the cleaning gas. Additionally or alternatively, activating the cleaning gas comprises forming plasma from the cleaning gas. The cleaning gas plasma may activate other cleaning gas molecules by decomposing them, and/or be used as such for chamber cleaning by etching. That is, in certain embodiments activated cleaning gas flow comprises atomic fluorine gas and other reactive by-products due to the decomposition of the cleaning gas by a plasma treatment. Additionally or alternatively, the activated cleaning gas flow comprises plasma formed from the cleaning gas.

The first activated cleaning gas flow is then routed to the reaction chamber 110 via the first inlet 120 and the second activated cleaning gas flow via the second inlet 180. In certain embodiments, when using plasma enhanced reactors as in the embodiment of Fig. 1, an integrated plasma formation (or activation) unit, for instance, the plasma antennae 125, that activates the plasma precursors during substrate processing is used to generate plasma to activate NF3, or other suitable cleaning gas, for the etching step. That is, the first NF3 cleaning gas flow fed through the first inlet 120 and the second cleaning gas flow fed through the second inlet 180 may both be activated to with plasma formed by the integrated plasma antennae 125 inside the reaction chamber 110. This way, in certain embodiments, the cleaning gas flows provided through the first and second inlets 120, 180 are not activated when first entering into the reaction chamber 100 but only after having reached the area of the plasma antennae 125 inside the reaction chamber 110. However, either way of doing the NF3 activation, before or after entering the reaction chamber 110, is feasible since the distribution of the plasma-activated cleaning gas inside the reaction chamber 110 may anyway be improved due to the two opposite flows. In certain embodiments, the plasma for activation is formed from the NF3 cleaning gas. In certain embodiments, there are separate plasma formation units for the first inlet 120 and the second inlet 180. In certain embodiments, the cleaning gas routed via the first inlet 120 is activated by the integrated plasma antennae 125 of the substrate processing apparatus 100 and the cleaning gas routed via the second inlet 180 is activated (plasma is formed from the cleaning gas) by a separate (remote) plasma formation (or activation) unit. In certain embodiments, only cleaning gas of the first cleaning gas flow or cleaning gas of the second cleaning gas flow is activated with plasma before entering the reaction chamber 110.

The simultaneous flow of NF3 from both the first inlet 120 and the second inlet 180 improve the distribution of the activated NF3 towards the side walls of the reaction chamber 110. Especially, gas flow to the top part and top corners of the reaction chamber 110 is improved (highlighted with dashed circles in Fig. 1) due to the NF3 flow from the two opposite inlets 120, 180 in embodiments, according toFig. 1. In comparison, if only the first inlet 120 was used, the NF3 distribution to the top part would be substantially weaker resulting in poorer cleaning of the reaction chamber 110 walls, longer etching time and bigger consumption of the cleaning gas. Hence, by feeding the NF3 also through the second inlet 180, the etching gas distribution inside the reaction chamber, etching rate, and cleaning efficacy may be improved. Further, the amount of required NF3 gas for etching may be reduced since areas inside the reaction chamber 110 with low NF3 dosage may be reduced.

Fig. 2 shows a further sectional view of a substrate processing apparatus according to an example embodiment. The reaction chamber 110 of the substrate processing apparatus 100 of Fig. 2 comprises a top part 130 and lower part, i.e., the reaction chamber bowl 210. During operation, the top part 130 and the reaction chamber bowl 210 are releasably sealed together by coupling means 220. For loading or removing substrate sample(s) 140, the reaction chamber 210 (together with the substrate support 150) may be lowered to open the reaction chamber 110, while the top part 130 remains stationary.

The first inlet 120, located at the top part 130 of the substrate processing apparatus 100 of Fig. 2, comprises a reactant channel 250 connected to a plurality of reactant inlets 260, and a plasma precursor channel 270 connected to a plurality of plasma inlets 280, and a plurality of plasma antennae 125, that is, an integrated plasma formation (or activation) unit. Note that only two plasma antennae are shown in Fig. 2, but other number of plasma antennae is possible, too. In certain embodiments, the plasma antennae 125 that are used during substrate processing are also used to generate plasma to activate the cleaning gas or to form plasma from the cleaning gas for the cleaning process. In certain embodiments, the plasma formed from the cleaning gas is used to activate other cleaning gas molecules by decomposition or to directly etch the reaction chamber.

During normal operation, non-plasma reactants (non-plasma precursors) are provided via the reactant channel 250 and reactant inlets 260 into the reaction chamber 110. The flow of non-plasma precursors inside the reactant channel 250 and to the reactant inlets 260 is depicted with dashed arrows in Fig. 2. The reactant inlets 260 are channels that extend from the first inlet ceiling into the reaction chamber 110 downstream of the plasma antennae 125. Therefore, the non-plasma precursors may be directly delivered to the reaction chamber 110 and undesired contacts with the plasma antennae 125 may be minimized.

For plasma-enhanced processing, plasma precursors are provided via the plasma precursor channel 270 and the plurality of plasma inlets 280.Tthe first inlet 120 of Fig. 2 comprises the precursor channel 270 and the plurality of plasma inlets 280. The cleaning gas used for chamber cleaning is also provided through the plasma precursor channel 270 and the plurality of plasma inlets 280. In certain embodiments, the cleaning gas serves as a plasma precursor. The flow of the plasma precursors and/or the cleaning gas in the first and second inlets 120, 180 is depicted with solid arrows in Fig. 2. Plasma precursors fed through the plasma precursor channel 270 and the plasma inlets 280 may come from the plasma precursor source 195 (for normal substrate processing with plasma or for generating plasma for cleaning gas activation), and the cleaning gas may come from the cleaning gas source 190 (to be decomposed or formed to plasma for chamber cleaning and etching).

In certain embodiments, the plurality of plasma inlets 280 are short channels protruding from the ceiling of the first inlet 120 that provide the plasma precursors and/or the cleaning gas upstream of the plasma antennae 125. In certain embodiments, the plasma inlets 280 are present as a plurality of holes in the ceiling of the first inlet 120 that distribute the plasma precursors to the reaction chamber 110 upstream of the plasma antennae 125. That is, the plasma precursors and/or cleaning gas must travel through the plasma antennae 125 on route into the reaction chamber 110. Accordingly, in certain embodiments the plasma antennae 125 are used to form plasma from the plasma precursors and/or the cleaning gas to activate cleaning gas for chamber etching. Additionally or alternatively, cleaning gas activation comprises forming plasma from the cleaning gas by the plasma antennae 125. In certain embodiments, the cleaning gas plasma is used to directly etch the reaction chamber 110 or to activate cleaning gas.

In an alternative embodiment, a separate (remote) plasma formation unit forms plasma from the plasma precursor flow(s) to activate, i.e., decompose the first and second cleaning gas flows to reactive species with plasma before the flows enter the reaction chamber 110. In certain embodiments, the remote plasma formation unit also forms plasma from the cleaning gas so that the cleaning gas is present as plasma when entering the reaction chamber 110. In certain embodiments, during the chamber cleaning, the plasma generated by the plasma antennae 125 also activates the cleaning gas that is provided via the substrate backside protection channel (the second inlet) 180 passing through the substrate support 150. It is noted that during the cleaning, the substrate 140 is not present in the reaction chamber 110 to avoid blocking of the second inlet 180 and damaging of the substrate 140.

In certain embodiments, the core of the substrate support 150 is hollow. In certain embodiments, the second cleaning gas flow is fed to the reaction chamber through the hollow substrate support 150. That is, the second cleaning gas flow may flow from the cleaning gas source 190 and through the substrate support 150 to effectively spread up into the reaction chamber 110. In certain embodiments, the second cleaning gas flow enters the reaction chamber 110 through a plurality of substrate support inlet holes 240 located on the substrate support 150 (but in other embodiments, there are less holes, and in certain embodiments only a single hole).

The cleaning gas of the second cleaning gas flow may be activated before or after entering the reaction chamber 110. In certain embodiments, the substrate support 150 is supported on the reaction chamber bowl 210 through supporting legs 230. There may be, for example, one, two, three, or four supporting legs 230. The backside protection channel enters the hollow substrate support 150 through one of the supporting legs 230. In certain embodiments, the backside protection channel operates as the second inlet 180. In certain embodiments, the second cleaning gas flow enters the substrate support 150 directly without passing through a support leg 230 (for example, through a separate tube extending up to inlet hole(s) 240, and the core of the substrate support may be hollow or non-hollow). In certain embodiments, the second cleaning gas flow is provided to the hollow substrate support 150 without the second inlet line 180 passing through the reaction chamber 110. For instance, the second inlet 180 may be directed in a channel inside a support leg 230 or separate structure such that the second inlet line 180 is not exposed to the reaction chamber 110.

The substrate support inlet hole(s) 240 direct the cleaning gas upwards towards the top of the reaction chamber 110 and the plasma antennae 125, that is, opposite to the first cleaning gas flow provided through the plasma inlets 280 of the first inlet 120. In certain embodiments, the activation of the cleaning gas provided via the backside protection channel (to form plasma) is performed by the plasma antennae 125. In an alternative embodiment, a separate remote plasma formation unit is used to activate the second cleaning as flow before it enters the reaction chamber 110 through the substrate support 150 and substrate support inlet hole(s) 240.

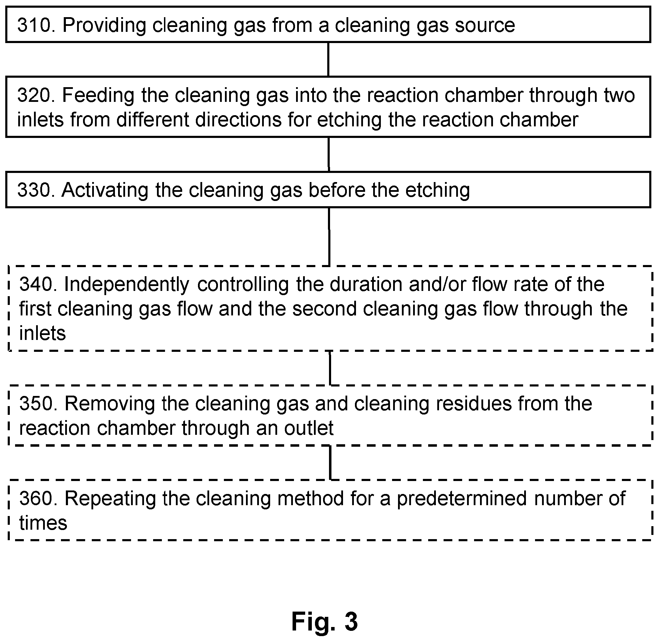

Fig. 3 shows a flow chart according to an example embodiment. Fig. 3 illustrates a process comprising various possible steps including some optional steps while also further steps can be included and/or some of the steps can be performed more than once. The process may be implemented, for example, in the substrate processing apparatus 100 of Fig. 1or Fig. 2. The process comprises the following steps:
310: Providing cleaning gas from a cleaning gas source. The cleaning gas may be provided from the cleaning gas source 190 of Fig. 1or Fig. 2. In certain embodiments, the cleaning gas is a fluorine-based gas. In certain embodiments, the cleaning gas is NF3. In certain embodiments, the fluorine-based cleaning gas is selected from the group of NF3, SF6, CF4, CHxFy and F2. In certain embodiments, the fluorine-based cleaning gas is selected from a group including but not limited to NF3, SF6, CF4, ChxFy and F2. In certain embodiments, the cleaning gas source 190 comprises more than one cleaning gas source. In certain embodiments, two different cleaning gases are provided to the first inlet and second inlet, respectively. In certain embodiments, only one type of cleaning gas (for example NF3) is provided.
320: Feeding the cleaning gas into the reaction chamber 110 through two inlets 120, 180 from different directions for etching the reaction chamber. In certain embodiments, the cleaning gas enters the reaction chamber in a not activated state. In certain embodiments, the cleaning gas enters the reaction chamber in an activated, i.e., decomposed state after being treated with plasma. In certain embodiments, the cleaning gas enters the reaction chamber 110 as plasma. In certain embodiments, the first inlet 120 providing the first cleaning gas flow is a showerhead. In certain embodiments, the second inlet 180 providing the second cleaning gas flow is the substrate backside protection channel. In certain embodiments, the first inlet 120 and the second inlet 180 are opposite to each other. In certain embodiments, the first cleaning gas flow from the first inlet 120 and the second cleaning gas flow form the second inlet 180 are directed at least partially towards each other. In certain embodiments, the first cleaning gas flow enters the reaction chamber 110 through the top of the reaction chamber 110 via the first inlet 120 and the second cleaning gas flow enters through the bottom of the reaction chamber 110 via the second inlet 180 opposite to the first inlet 120. In certain embodiments, the second cleaning gas flow enters from below through the substrate support 150. In certain embodiments, a first cleaning gas flow is directed downwards while at the same time the second cleaning gas flow is directed upwards towards the first cleaning gas flow. In certain embodiments, at least one of the first cleaning gas flow and second cleaning gas flow enter the reaction chamber 110 from the side.
330: Activating the cleaning gas with plasma before the etching. In certain embodiments, the cleaning gas is activated with plasma after it has been fed through the two opposite inlets 120, 180. In certain embodiments, the cleaning gas is activated with plasma before it is fed through the first inlet 120 and the second inlet 180, that is, the cleaning gas enters the reaction chamber 110 in an activated state. In certain embodiments, the fluorine-based cleaning gas is activated with plasma generated by a plasma formation unit. In certain embodiments, the plasma is argon plasma or nitrogen plasma. In certain embodiments, the plasma is plasma from the fluorine-based cleaning gas. In certain embodiments, at least one of the first cleaning gas flow and second cleaning gas flow is activated with plasma before entering the reaction chamber 110.

The cleaning gas may be formed to plasma to activate cleaning gas. In certain embodiments, the cleaning gas plasma is used for chamber etching. When activated with plasma, the NF3 molecule decomposes to atomic fluorine gas and other reactive by-products that react willingly with almost all materials. Hence, it can be used to etch solid materials from surfaces of the reaction chamber 110. In certain embodiments, the plasma formation unit is a separate plasma unit. In certain embodiments, the plasma formation unit is the integrated plasma formation unit, e.g., a plurality of plasma antennae 125, of a plasma enhanced substrate processing apparatus 100. That is, the plasma formation unit for generating plasma for cleaning gas activation may be the same plasma formation unit that is used also for substrate processing.

340: The process optionally comprises independently controlling the duration and/or flow rate of the first cleaning gas flow and the second cleaning gas flow through the inlets 120, 180. In certain embodiments, the cleaning gas is injected simultaneously through the two opposite inlets, that is, the first inlet 120 and the second inlet 180. In certain embodiments, the cleaning gas enters the reaction chamber 110 simultaneously through the first inlet 120 and the second inlet 180. In certain embodiments, the duration of the cleaning gas flows through both inlets is 5 min, 10 min, 15, min, 20 min, or 30 min. In certain embodiments, the cleaning gas is injected into the reaction chamber for at least 5 min in total. In certain embodiments, the flow duration is determined by a user. In certain embodiments, the flow duration is automatically determined and adjusted by a computing device. In certain embodiments, the cleaning gas is pulsed to the reaction chamber 110 through the first and second inlets. In certain embodiments, the cleaning gas pulse time is 15-300 s followed by an inert gas (such as N₂) purge, wherein the purge duration is 10-200 s. In certain embodiments, the total cleaning gas pulse time is 10, 20, or 30 min, or 5-30 min. In certain embodiments, the duration of cleaning gas pulse(s) is longer than the duration of purge(s). In certain embodiments, N₂ is used as a carrier gas for the cleaning gas.

In certain embodiments, the reaction chamber 110 has elevated temperature during the cleaning. In certain embodiments, the reaction chamber temperature during cleaning is 50-200 °C, for example 125 °C. In certain embodiments, the reaction chamber temperature during cleaning is at least 125 °C. In certain embodiments, the reaction chamber 110 and substrate support 150 have the same temperature during cleaning.

In certain embodiments, the flow rate of the first cleaning gas flow is equal to the flow rate of the second cleaning gas flow rate. In certain embodiments, the flow rate is 50, 100, 150, 200, or 300 sccm. In certain embodiments, the flow rate is 20-500 sccm. In certain embodiments, the flow rate is more than 500 sccm. In certain embodiments, the flow rate from the two opposite inlets 120, 180 is not equal. In certain embodiments, the cleaning gas flow through the first inlet 120 (top) has higher flow rate than the second cleaning gas flow through the second inlet 180 (bottom). In certain embodiments, the first inlet 120 (top) has lower flow rate than the bottom inlet 180 (bottom). In certain embodiments, the ratio of the flow rate from the first inlet 120 to the flow rate from the second inlet 180 is from 6:1 to 1:6. In certain embodiments, the maximum ratio of the flow rate from the first inlet 120 to the flow rate from the second inlet 180 is 10:1 In certain embodiments, the minimum ratio of the flow rate from the first inlet 120 to the flow rate from the second inlet is 1:10. In certain embodiments, the relative flow rate of the two opposite inlets 120, 180 is varied during the cleaning process while the total flow rate is kept constant. In certain embodiments, the flow rates are controlled automatically by a computing device, such as a general-purpose personal computer.

In certain embodiments, the durations and/or flow rates of the first cleaning gas flow and the second cleaning gas flow through the two opposite inlets 120, 180 are individually controlled to target the total cleaning gas flow inside the reaction chamber 110. In certain embodiments, the durations and/or the flow rates are controlled to direct most of the cleaning gas to the areas of the reaction chamber 110 that require most cleaning. For instance, when the top part of the reaction chamber has been observed to suffer from chemical accumulation, a higher flow rate from the bottom inlet can be used to focus most of the cleaning gas flow towards the top of the reaction chamber 110. In certain embodiments, the flow rates are determined manually by a user. In certain embodiment, the flow rates are determined automatically by a computing device.

In certain embodiments, the cleaning gas is injected into the reaction chamber sequentially by alternating the cleaning gas flow through two opposite inlets 120, 180 for etching the reaction chamber with the activated cleaning gas. In certain embodiments, the cleaning gas is injected sequentially into the reaction chamber 110 by alternating the cleaning gas flow between the two opposite inlets 120, 180. For instance, cleaning gas may flow first only from the first inlet 120 while the second inlet 180 is closed; thereafter, the first inlet 120 is closed and the cleaning gas is allowed to flow through the second inlet 180. In certain embodiments, the cleaning gas is injected first from the first inlet 120 (top) and then from the second inlet 180 (bottom). In certain embodiments, the cleaning gas is injected first from the second inlet 180 (bottom) and then from the first inlet 120 (top).

In certain embodiments, the durations of the first cleaning gas flow (first injection) from the first inlet 120 is equal to the second cleaning gas flow (second injection) from the second inlet 180. In certain embodiments, the duration of each sequential injection is 30, 60, 120, or 180 s. In certain embodiments, the durations of the sequential injections are not equal. For instance, in certain embodiments, the duration of the first injection is 60, 120, 180, 240, or 300 s, and the duration of second injection 30, 60, 120, or 180 s, respectively. For example, in certain embodiments, the duration of the first injection is 30, 60, 120, or 180 s, and the duration of the second injection 60, 120, 180, 240, or 300 s, respectively. For clarity, it is noted that the first injection is the cleaning gas injection that occurs first and the second injection is the injection performed after the first injection. That is, the first injection does not necessarily occur from the first inlet 120 and the second inlet from the second inlet 180.

In certain embodiments, the flow rates of the sequential injections are equal. In certain embodiments, the flow rate of both the first and second injection is 20-500 sccm. In certain embodiments, the flow rates of the sequential injections are not equal. In certain embodiments, the ratio of the first injection rate to the second injection rate is 20-500 sccm In certain embodiments, the ratio of the first injection rate to the second injection rate is 20-500 sccm.

Advantageously, individually controlling the flow rate and duration of the first and the second injection separately allows targeting of the cleaning gas inside the reaction chamber according to the accumulation of chemicals. For instance, if most of the accumulated chemical contamination resides in the top part of the reaction chamber, the flow rate and duration of the cleaning gas flow from the backside protection channel 180 may be increased and the flow from the showerhead 120 kept shorter and less intense. Hence, the cleaning gas flow may especially be targeted to the top part of the reaction chamber 110 whereas less intense cleaning is required in the bottom part. Vice versa, if the top part of the reaction chamber 110 is observed to be clean, higher flow rate and longer duration of the flow from the showerhead 120 may be preferred to direct most of the cleaning gas downwards to the bottom of the reaction chamber 110. In general, distribution of the activated cleaning gas inside the reaction chamber 110 is improved due to the two cleaning gas flows from the two opposite inlets 120, 180.

350: The process optionally comprises removing the cleaning gas from the reaction chamber through the outlet 160. In certain embodiments, a vacuum pump 170 is used to remove the cleaning gas and cleaning residues from the reaction chamber 110.

360: The process optionally comprises repeating the cleaning process for a predetermined number of times. In certain embodiments, the steps 310-350 are repeated for a predetermined number of times. In certain embodiments, the flow rate and duration from the first inlet and/or from the second inlet are different for each cleaning process repetition cycle. Advantageously, each cleaning cycle may target majority of the activated cleaning gas flow towards a certain part of the reaction chamber 110. In certain embodiments, simultaneous and sequential activated cleaning gas injections are alternated in the repeated cleaning cycles. In certain embodiments, the cleaning process with simultaneous cleaning gas injection from the two opposite inlets 120, 180 is repeated 1, 2, 3, or 4 times. In certain embodiments, the cleaning process with sequential cleaning gas injection from the two opposite inlets 120, 180 is repeated 1, 2, 3, or 4 times. In certain embodiments, the amount of cleaning process cycles is determined case-specifically based on the observed condition of the reaction chamber. In certain embodiments, the cleaning process alternates between simultaneous and sequential cleaning gas injection.

Without limiting the scope and interpretation of the patent claims, certain technical effects of one or more of the example embodiments disclosed herein are listed in the following. A technical effect is improved cleaning gas distribution inside a reaction chamber. A further technical effect is improved reaction chamber cleaning efficacy. A further technical effect is improved process quality due to less contamination. A further technical effect is reduced consumption of cleaning gas during the chamber cleaning. A further technical effect is reduced etching time due to more efficient cleaning gas distribution. A further technical effect is improved control and targeting of the cleaning gas flow inside a reaction chamber.

Various embodiments have been presented. It should be appreciated that in this document, words comprise, include, and contain are each used as open-ended expressions with no intended exclusivity.

The foregoing description has provided by way of non-limiting examples of particular implementations and embodiments a full and informative description of the best mode presently contemplated by the inventors for carrying out the invention. It is however clear to a person skilled in the art that the invention is not restricted to details of the embodiments presented in the foregoing, but that it can be implemented in other embodiments using equivalent means or in different combinations of embodiments without deviating from the characteristics of the invention.

Furthermore, some of the features of the afore-disclosed example embodiments may be used to advantage without the corresponding use of other features. As such, the foregoing description shall be considered as merely illustrative of the principles of the present invention, and not in limitation thereof. Hence, the scope of the invention is only restricted by the appended patent claims.

Various examples of the present disclosure are herein described as numbered examples:
Example 1. A method for cleaning a reaction chamber of a substrate processing apparatus, comprising:
   providing cleaning gas from a cleaning gas source;
   feeding a first cleaning gas flow through a first inlet and a second cleaning gas flow through a second inlet into the reaction chamber for etching the reaction chamber, wherein the first cleaning gas flow and the second cleaning gas flow enter the reaction chamber from different directions; and
   activating the cleaning gas before said etching.
Example 2. The method of example 1, wherein said activating comprises at least one of decomposing the cleaning gas with plasma and forming plasma from the cleaning gas.
Example 3. The method of example 1 or 2, comprising:
   feeding the cleaning gas into the reaction chamber simultaneously through the first inlet and the second inlet.
Example 4. The method of example 1 or 2, comprising:
   feeding the cleaning gas into the reaction chamber sequentially through the first inlet and the second inlet.
Example 5. The method of any preceding example, wherein the cleaning gas is a fluorine-based gas.
Example 6. The method of any preceding example, wherein the cleaning gas of the first cleaning gas flow is different from the cleaning gas of the second cleaning gas flow.
Example 7. The method of any preceding example, wherein the first inlet and the second inlet are opposite to each other.
Example 8. The method of any preceding example, wherein the second inlet is a substrate backside protection channel.
Example 9. The method of any preceding example, wherein the first cleaning gas flow enters the reaction chamber through the top of the reaction chamber via the first inlet and the second cleaning gas flow enters through the bottom of the reaction chamber via the second inlet opposite to the first inlet.
Example 10. The method of any preceding example, wherein at least one of the two inlets is also used for feeding reaction chemicals during substrate processing.
Example 11. The method of any preceding example, comprising:
   repeating the method for a predetermined number of times.
Example 12. The method of any preceding example, comprising:
   activating the cleaning gas with plasma formed in a separate plasma formation unit.
Example 13. The method of any one of the examples 1-11, comprising:
   activating the cleaning gas with plasma formed in a plasma formation unit integrated into the reaction chamber.
Example 14. The method of any preceding example, comprising:
   activating the cleaning gas of the first cleaning gas flow and the cleaning gas of the second cleaning gas flow with plasma formed in a single plasma formation unit.
Example 15. The method of any preceding example, comprising:
   forming plasma for activating the cleaning gas and forming plasma used for substrate processing in a same plasma formation unit.
Example 16. The method of any preceding example, comprising:
   targeting cleaning gas flow inside the reaction chamber by controlling the duration and/or the flow rate of the first cleaning gas flow and the second cleaning gas flow.
Example 17. A substrate processing apparatus, comprising:
   a reaction chamber;
   a first inlet to feed cleaning gas as a first cleaning gas flow from a cleaning gas source into the reaction chamber;
   a second inlet to feed cleaning gas, from a direction that differs from a direction of feed of the first cleaning gas flow, as a second cleaning gas flow from the cleaning gas source into the reaction chamber; and
   a plasma formation unit configured to activate the cleaning gas for etching the reaction chamber.
Example 18. The substrate processing apparatus of example 17, wherein the plasma formation unit is configured to activate cleaning gas by at least one of decomposing the cleaning gas with plasma and forming plasma from the cleaning gas.
Example 19. The substrate processing apparatus of example 17 or 18, wherein the plasma formation unit is an integrated plasma formation unit integrated into the reaction chamber.
Example 20. The substrate processing apparatus of example 17 or 18, comprising a remote plasma formation unit for forming plasma to activate the cleaning gas before feeding the cleaning gas into the reaction chamber.
Example 21. The substrate processing apparatus of any one of the examples 17-20, wherein the first inlet line and the second inlet line are opposite to each other.
Example 22. The substrate processing apparatus of any one of the examples 17-21, configured to feed the first cleaning gas flow and the second cleaning gas flow simultaneously into the reaction chamber.
Example 23. The substrate processing apparatus of any one of the examples 17-21, configured to feed the first cleaning gas flow and the second cleaning gas flow sequentially into the reaction chamber.
Example 24. The substrate processing apparatus of any one of the examples 17-23, wherein the cleaning gas is a fluorine-based gas.
Example 25. The substrate processing apparatus of any one of the examples 17-24, wherein the cleaning gas of the first cleaning gas flow is different from the cleaning gas of the second cleaning gas flow.
Example 26. The substrate processing apparatus of any one of the examples 17-25, wherein the second inlet is a substrate backside protection channel.

## Claims

1. A method for cleaning a reaction chamber (110) of a substrate processing apparatus (100), comprising:
providing (210) cleaning gas from a cleaning gas source (190);
feeding (230) a first cleaning gas flow through a first inlet (120) and a second cleaning gas flow through a second inlet (180) into the reaction chamber (110) for etching the reaction chamber (110), wherein the first cleaning gas flow and the second cleaning gas flow enter the reaction chamber (110) from different directions; and
activating the cleaning gas before said etching.

2. The method of claim 1, wherein said activating comprises at least one of decomposing the cleaning gas with plasma and forming plasma from the cleaning gas.

3. The method of claim 1 or 2, comprising:
feeding the cleaning gas into the reaction chamber (110) simultaneously through the first inlet (120) and the second inlet (180).

4. The method of claim 1 or 2, comprising:
feeding the cleaning gas into the reaction chamber (110) sequentially through the first inlet (120) and the second inlet (180).

5. The method of any preceding claim, wherein the cleaning gas is a fluorine-based gas.

6. The method of any preceding claim, wherein the cleaning gas of the first cleaning gas flow is different from the cleaning gas of the second cleaning gas flow.

7. The method of any preceding claim, wherein the first inlet (120) and the second inlet (180) are opposite to each other.

8. The method of any preceding claim, wherein the second inlet (180) is a substrate backside protection channel.

9. The method of any preceding claim, wherein the first cleaning gas flow enters the reaction chamber (110) through the top of the reaction chamber (110) via the first inlet (120) and the second cleaning gas flow enters through the bottom of the reaction chamber (110) via the second inlet (180) opposite to the first inlet (120).

10. The method of any preceding claim, wherein at least one of the two inlets is also used for feeding reaction chemicals during substrate processing.

11. The method of any preceding claim, comprising:
repeating (360) the method for a predetermined number of times.

12. The method of any preceding claim, comprising:
activating the cleaning gas with plasma formed in a separate plasma formation unit.

13. The method of any one of the claims 1-11, comprising:
activating the cleaning gas with plasma formed in a plasma formation unit integrated into the reaction chamber (110).

14. The method of any preceding claim, comprising:
targeting cleaning gas flow inside the reaction chamber (110) by controlling the duration and/or the flow rate of the first cleaning gas flow and the second cleaning gas flow.

15. A substrate processing apparatus (100), comprising:
a reaction chamber (110);
a first inlet (120) to feed cleaning gas as a first cleaning gas flow from a cleaning gas source (190) into the reaction chamber (110);
a second inlet (180) to feed cleaning gas, from a direction that differs from a direction of feed of the first cleaning gas flow, as a second cleaning gas flow from the cleaning gas source (190) into the reaction chamber (110); and
a plasma formation unit configured to activate the cleaning gas for etching the reaction chamber (110).
